# EUROPEAN PATENT APPLICATION

(11) **EP 4 300 742 A1**
(43) Date of publication of application: **03.01.2024**
(21) Application number: 22215837.0
(22) Date of filing: 22.12.2022
(51) Int. Cl.: H02H 3/16, G01R 31/52

(54) **ELECTRIC LEAKAGE PROTECTION DEVICE FOR POOL APPARATUS, AND POOL APPARATUS**

(30) Priority: 28.06.2022 CN 202221646176 U
(71) Applicant: Bestway Inflatables & Material Corp., Shanghai 201812 (CN)
(72) Inventor: ZENG, Xianglin, SHANGHAI, 201812 (CN)
(74) Representative: Inchingalo, Simona

(57) **Abstract**

An electric leakage protection device for a pool apparatus is provided. The electric leakage protection device may be arranged on a control board of the pool apparatus. The electric leakage protection device comprises: a leakage current detection module configured to detect whether there is a leakage current in a ground wire; and a control circuit operatively connected to the leakage current detection module, wherein the leakage current detection module transmits an electric leakage detection signal to the control circuit in response to detecting the leakage current.

## Description

### CROSS-REFERENCE TO RELATED APPLICATION

This Application claims priority from Chinese Application CN 202221646176.0, filed June 28, 2022 in China.

### BACKGROUND

### 1. Field

Apparatuses and methods consistent with example embodiments relate to an electric leakage protection device for a pool apparatus, and a pool apparatus comprising the electric leakage protection device.

### 2. Description of the Related Art

In addition to traditional swimming pools and outdoor lakes, rivers and oceans, various pool products have been developed such as a pool apparatus. One type of pool apparatus is an inflatable solus par agula (SPA) pool. A pool apparatus typically comprises at least one response device, such devices for heating or cooling water or other liquid held by the pool apparatus, for generating mists of any of various smells, for emitting any of various lights, for adjusting a water volume, for filtering water, for generating air bubbles or water flow to provide a massage effect, etc. However, if electric leakage occurs in the pool apparatus, it is likely to cause safety hazards to users.

With respect to detection of electric leakage of heaters of water storage apparatuses, a current between different detection points of a water body inside the heater may be detected using a sensing probe so as to detect leakage current in the water. However, such electric leakage detection is generally used only to prevent electric leakage of a live wire or a neutral wire, and electric leakage with respect to ground is not detected. For example, a possible cause of electric leakage may be a misconnection of a neutral wire or a ground wire, poor grounding, or disconnection of a ground wire. Likewise, electric leakage may cause leakage current to flow into a pool product from a common ground wire, of another electric apparatus.

In order to prevent electric leakage with respect to a ground wire, existing products may use an external electric leakage protection plug, which requires a manual self-check to determine whether the electric leakage protection function is good, and after an electric leakage protection circuit achieves trip protection, a circuit control board is generally powered off and thus fault information cannot displayed, so that the user cannot know the status of the apparatus.

### SUMMARY

Example embodiments may address at least the above problems and/or disadvantages and other disadvantages not described above. Also, example embodiments are not required to overcome the disadvantages described above, and may not overcome any of the problems described above.

According to an aspect of an example embodiment, an electric leakage protection device comprises: a leakage current detection module configured to detect whether there is a leakage current in a ground wire; and a control circuit operatively connected to the leakage current detection module, wherein the leakage current detection module transmits an electric leakage detection signal to the control circuit in response to detecting the leakage current.

The leakage current detection module may comprise: a current transducer configured to sense the leakage current in the ground wire passing therethrough; a sampling circuit coupled to a current signal output end of the current transducer, and configured to obtain a sampling voltage signal; a first filter circuit comprising an input end coupled to the sampling circuit, and configured to convert the sampling voltage signal into a processed voltage signal; a bias circuit that outputs a direct-current bias voltage; an amplification processing circuit coupled to an output end of the first filter circuit and to an output end of the bias circuit and configured to amplify the processed voltage signal and thereby obtain an amplified voltage signal; and a second filter circuit comprising an input end coupled to an output end of the amplification processing circuit and configured to convert the amplified voltage signal into the electric leakage detection signal.

The amplification processing circuit may comprise: an amplification circuit coupled to the output end of the first filter circuit and to the output end of the bias circuit and configured to amplify the processed voltage signal and thereby obtain an amplified signal; and a third filter circuit comprising an input end coupled to an output end of the amplification circuit and configured to convert the amplified signal into the amplified voltage signal.

The amplification processing circuit may comprise: an amplification circuit, coupled to the output end of the first filter circuit and to the output end of the bias circuit and configured to amplify the processed voltage signal to obtain an amplified signal; and a buffer circuit comprising an input end coupled to an output end of the amplification circuit and configured to convert the amplified signal into the amplified voltage signal.

The amplification processing circuit may comprise: an amplification circuit coupled to the output end of the first filter circuit and to the output end of the bias circuit and configured to amplify the processed voltage signal and thereby obtain an amplified signal; and a third filter circuit comprising an input end coupled to an output end of the amplification circuit and configured to convert the amplified signal into a processed amplified signal; and a buffer circuit comprising an input end coupled to an output end of the third filter circuit and configured to convert the processed amplified signal into the amplified voltage signal.

The amplification processing circuit may comprise: an amplification circuit coupled to the output end of the first filter circuit and to the output end of the bias circuit and configured to amplify the processed voltage signal and thereby obtain the amplified voltage signal.

The electric leakage protection device may further comprise an alarm module, wherein the control circuit is further connected to the alarm module and configured to control the alarm module to output an alarm.

The electric leakage protection device may further comprise an operation panel of a pool apparatus, wherein the control circuit is operatively connected to the operation panel and thereby receives a control command that is input by a user by means of the operation panel.

The operation panel may comprise a display screen.

The control circuit may be communicatively connected to the display screen through serial communication.

The control circuit may transmit fault information associated with the ground wire to the display screen, and thereby control the display screen to display the fault information.

The control circuit may be configured to connect to an external device via a wireless network, and to thereby receive a control command that is input by a user from the external device via the wireless network.

The control circuit may transmit fault information associated with the ground wire to the external device via the wireless network.

The control circuit may be further connected to at least one response device of the pool apparatus, and the electric leakage protection device may further comprise a switch module, coupled between a power interface and the at least one response device, and configured to control a power connection of a power supply line between the power interface and the at least one response device, wherein the control circuit is further connected to the switch module and configured to control the switch module to establish or break the power connection.

The control box may comprise: a control board; and the electric leakage protection device described above, arranged on the control board.

The pool apparatus may further comprise an operation panel, and the control circuit may be connected to the operation panel of the pool apparatus and be thereby configured to receive a control command that is input by a user by means of the operation panel.

The pool apparatus may further comprise at least one response device, and the control circuit may be further connected to the at least one response device; and the electric leakage protection device may further comprise a switch module, coupled between a power interface (or power source) and the at least one response device, and be configured to control power connection of a power supply line between the power interface (or power source) and the at least one response device, wherein the control circuit transmits a switch control signal to the switch module according to the electric leakage detection signal and is thereby configured to control the switch module to establish or break the power connection.

The pool body may comprise one of an inflatable massage pool body, a rigid massage pool body, and a frame pool body.

### BRIEF DESCRIPTION OF THE DRAWINGS

The above and/or other aspects will become apparent and more readily appreciated from the following description of example embodiments, taken in conjunction with the accompanying drawings, in which:
FIG. 1 is a schematic block diagram of a pool apparatus according to an example embodiment.
FIG. 2 is a schematic block diagram of an electric leakage protection system comprising an electric leakage protection device according to an example embodiment.
FIG. 3 is a schematic block diagram of a leakage current detection module in an electric leakage protection device according to an example embodiment.
FIG. 4 shows a first example circuit of a leakage current detection module according to an example embodiment.
FIG. 5 shows a second example circuit of a leakage current detection module according to an example embodiment.FIG. 6 shows a third example circuit of a leakage current detection module according to an example embodiment.
FIG. 7 shows a fourth example circuit of a leakage current detection module according to an example embodiment.
FIG. 8 shows an example control circuit and connection thereof according to an example embodiment.

### DETAILED DESCRIPTION

Reference will now be made in detail to example embodiments which are illustrated in the accompanying drawings, wherein like reference numerals refer to like elements throughout. In this regard, the example embodiments may have different forms and may not be construed as being limited to the descriptions set forth herein.

It will be understood that the terms "include," "including", "comprise, and/or "comprising," when used in this specification, specify the presence of stated features, integers, steps, operations, elements, and/or components, but do not preclude the presence or addition of one or more other features, integers, steps, operations, elements, components, and/or groups thereof.

It will be further understood that, although the terms "first," "second," "third," etc., may be used herein to describe various elements, components, regions, layers and/or sections, these elements, components, regions, layers and/or sections may not be limited by these terms. These terms are only used to distinguish one element, component, region, layer or section from another element, component, region, layer or section.

As used herein, the term "and/or" includes any and all combinations of one or more of the associated listed items. Expressions such as "at least one of," when preceding a list of elements, modify the entire list of elements and do not modify the individual elements of the list.

Various terms are used to refer to particular system components. Different companies may refer to a component by different names - this document does not intend to distinguish between components that differ in name but not function.

Matters of these example embodiments that are obvious to those of ordinary skill in the technical field to which these exemplary embodiments pertain may not be described here in detail.

As noted, possible reasons for electric leakage of a ground wire may be a misconnection of a neutral wire and a ground wire, poor grounding or disconnection of a ground wire, or electric leakage, causing leakage current to flow into a pool product through a main ground wire, of another electric apparatus. For example, most households have a variety of electrical apparatuses, such as washing machines, refrigerators, air conditioners, etc., that typically have Y-capacitors connected across a ground wire and live and neutral wires, and such Y-capacitors may cause leakage of weak alternating current to the ground wire. In addition, failure of such an apparatus may result in leakage of current to the ground wire. If the leakage current on the ground wire flows to the pool apparatus, it may affect personal safety, such as pain, numbness, burn at the part subjected to electric shock, and even death. For example, when an alternating current of 1mA flows through a human body, the human body will have a feeling of electric shock of numbness, stabbing pain, etc. A leakage current flowing through the human body exceeding a specific alternating current value (e.g., the safe current of the human body is 10 mA, and the specific alternating current value may be set as required to be, e.g., 1 mA, 2 mA, 5 mA, etc.) is not allowed, thus the threshold of an electric leakage protection switch is generally above the specific alternating current value (e.g., 1 mA, 2 mA, 5 mA, etc.).

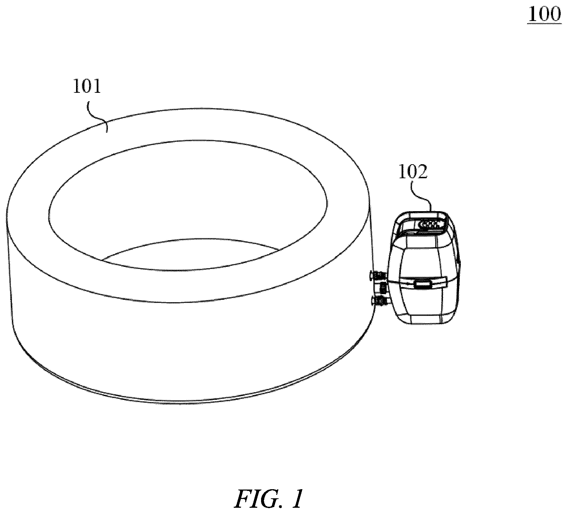

FIG. 1 shows a schematic illustration of a pool apparatus 100 according to an example embodiment. The pool apparatus 100 comprises a pool body 101. The pool body 101 may have any of various shapes, such as circular, oval, rectangular, square, polygonal, or any of various irregular shapes. The pool body 101 in this example embodiment is an inflatable pool, such as an inflatable SPA pool, in which an inflatable chamber may be formed by waterproof cloth or a polyvinyl chloride (PVC) material. The pool body may alternately be a frame pool, which may also be constructed from waterproof cloth or a PVC material with a bracket. Of course, the pool body may alternately be a rigid SPA pool, and other designs and materials may be adjusted according to different needs. The pool body 101 is used for holding water or other liquid to allow a user to move therein. The pool apparatus 100 further comprises a control box 102, and an electric leakage protection device may be provided in the control box 102 to detect the electric leakage of a ground wire in real time.

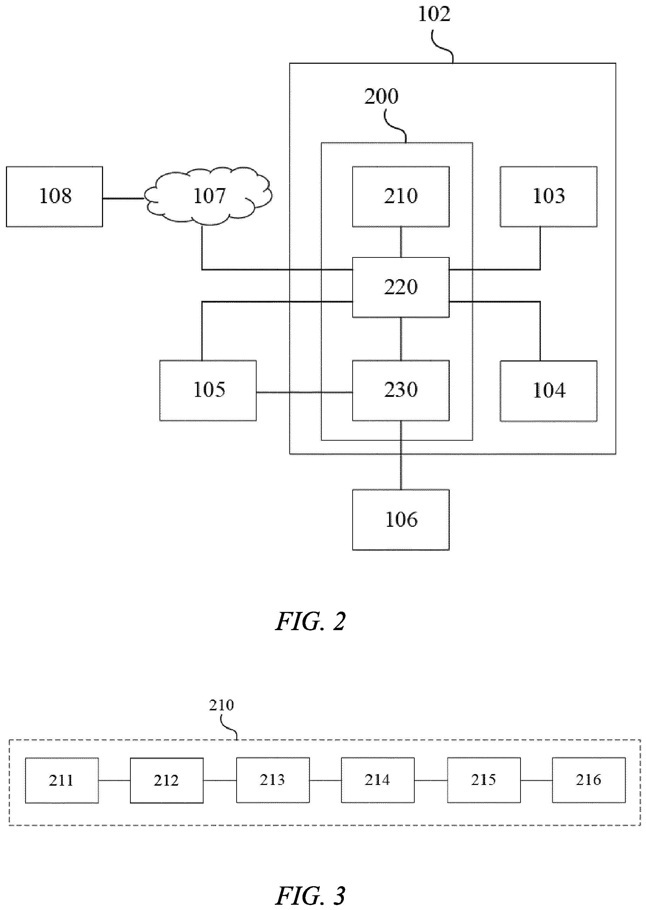

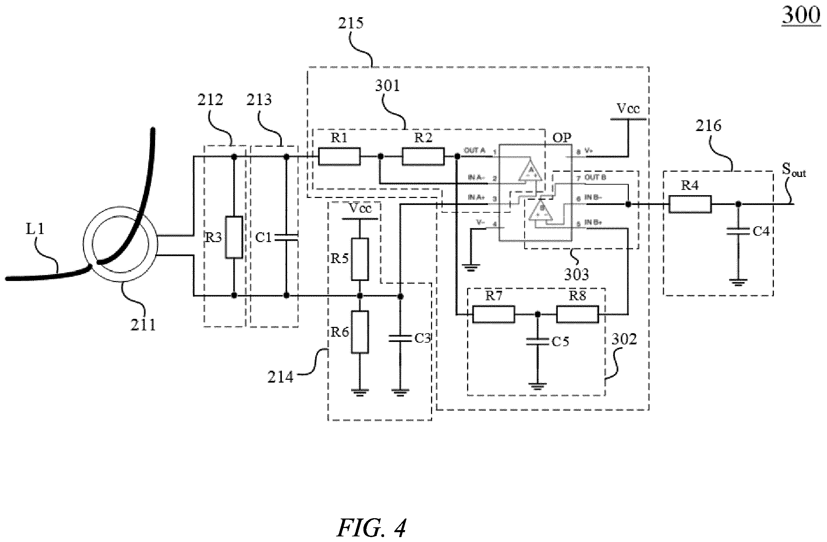

FIG. 2 shows a schematic block diagram of an electric leakage protection system comprising an electric leakage protection device 200 according to an example embodiment. The electric leakage protection device 200 may be installed in the control box 102 of the pool apparatus 100 in FIG. 1, for example, on a control board. The electric leakage protection device 200 comprises a leakage current detection module 210 and a control circuit 220 connected to the leakage current detection module 210. The leakage current detection module 210 is configured to detect whether there is a leakage current in a ground wire L1 (see FIGs. 4-7) of the pool apparatus 100, and to transmit an electric leakage detection signal, Sout, to the control circuit 220 in response to detecting the leakage current (see FIGs. 4-7).

Compared with existing electric leakage detectors (e.g., a live wire or neutral wire electric leakage detector) and electric leakage protection devices (e.g., an external electric leakage protection plug) for pool apparatuses, the electric leakage protection device 200 may detect the electric leakage of the ground wire in real time, and may further improve the level of system integration by the electric leakage protection device 200 being internally disposed on the control board of the pool apparatus 100. Thus, it may be convenient for the device 200 to communicate with other components of the pool apparatus 100 via the control board.

In some examples, an alarm module 104 may be provided at the control box 102 (e.g., the control board), and the control circuit 220 may be connected to the alarm module 104 to control the alarm module 104 to output an alarm. For example, the control circuit 220 transmits an alarm control signal to the alarm module 104 according to an electric leakage detection signal from the leakage current detection module 210, and the alarm module 104 outputs an alarm in response to the alarm control signal, such that the user can know a safety status of the pool apparatus.

In some examples, an operation panel 103 may be provided at the control box 102, and the control circuit 220 may be connected to the operation panel 103 to receive a control command regarding the pool apparatus that is input by the user by means of the operation panel 103. For example, the operation panel 103 may be provided with one or more input devices, such as buttons, a touch screen, or a microphone, to receive user input. Under normal circumstances, the control circuit 220 may execute a preset operation process (e.g., a heating or cooling process, etc.) based on a corresponding control command received from the operation panel 103. However, the operation process may injure the user if serious electric leakage of the ground wire occurs. Therefore, the control circuit 220 may determine the level of severity or risk of the electric leakage of the ground wire according to the electric leakage detection signal from the leakage current detection module 210, so as to disable or enable the control command from the operation panel 103 to execute the preset operation process.

In some examples, the operation panel 103 may comprise a display screen. For example, the display screen may display the control command that is input by the user. The control circuit 220 may be communicatively connected to the display screen through a serial communication. For example, the control circuit 220 may be connected to a display screen, having no processor, via a display chip through serial communication, or the control circuit 220 may be connected to a display screen, having a processor, through serial communication. The control circuit 220 may transmit, to the display screen, fault information associated with the electric leakage of the ground wire so the fault information is displayed by means of the display screen, such that the user can know the safety status of the pool apparatus when the electric leakage of the ground wire occurs. For example, the fault information may include whether there is electric leakage of the ground wire, the level of the electric leakage of the ground wire, etc. In addition, the display screen may also be used to display other information, for example, operation status and parameters, mode settings, control commands input by the user, etc., about the pool apparatus

In some examples, the control circuit 220 may be connected to an external device 108 via a wireless network 107. The external device 108 may be pre-paired with the control circuit 220. For example, the external device 108 may be a remote control paired with the control circuit 220 via the wireless network 107 (e.g., a radio frequency network or a Bluetooth network). Alternatively, the external device 108 may not need to be pre-paired with the control circuit 220, but may interact with the control circuit 220 through a protocol via the wireless network 107 (e.g., WiFi or a cellular network, etc.). For example, the external device 108 may be a cell phone, a tablet personal computer, or another portable device that performs information interaction with the control circuit 220 via an application (e.g., a browser or a specific application) installed on the external device 108. The control circuit 220 may receive, from the external device 108, the control command that is input by the user. The control circuit 220 may transmit fault information associated with the ground wire to the external device 108 via the wireless network 107. For example, the external device 108 may be provided with a display screen similar to the operation panel 103 to display the fault information mentioned above or other information of the pool apparatus.

In some examples, the pool apparatus 100 further comprises at least one response device 105. For example, the response device 105 may be a device for heating or cooling water or other liquid held by the pool apparatus, such as a device that can generate mist of any of various smells, emit light, adjust the water volume, filter the water in the pool, generate air bubbles or water flow to provide a massage effect, etc. The response device 105 may be integrated in the control box 102 or at another position of the pool apparatus 100, and the control circuit 220 may be connected to the response device 105 to control the response device 105 to execute a preset operation process according to a control command (e.g., from the operation panel 103 or the external device 108). The control circuit 220 may determine the level of severity or risk of electric leakage of the ground wire according to the electric leakage detection signal from the leakage current detection module, so as to disable or enable the control command from the operation panel 103 to control the response device 105 to execute the corresponding preset operation process.

In some examples, the electric leakage protection device 200 may further comprise a switch module 230. The switch module 230 is coupled between a power interface 106 and the at least one response device 105 of the pool apparatus 100 to control the power connection of a power supply line between the power interface 106 and the response device 105. The control circuit 220 may be connected to the switch module 230 to control the switch module 230 to establish or break the power connection. For example, the control circuit 220 may determine the degree of severity or risk of the electric leakage of the ground wire based on the electric leakage detection signal from the leakage current detection module 210 and then transmit a switch control signal to the switch module 230 so as to control the switch module 230 to establish or break the power connection.

The power supply line or loop may include, for example, a live wire L and a neutral wire N. The power supply line and the response device 105 may thus form a conductive loop when the switch module 230 is controlled to maintain or establish the power connection, and the power supply line or the response device 105 is powered off when the switch module 230 is controlled to break the power connection. For example, the switch module 230 may be designed to be closed to achieve conduction of the power supply line and designed to be open to disconnect the power supply line after serious electric leakage of the ground wire occurs, thereby achieving ground leakage protection. For example, the switch module 230 may comprise one or more switch assemblies provided on the live wire and/or the neutral wire. Each switch assembly is used to control the power connection of the power supply line between the power input interface 106 and the response device 105, such that each switch assembly may implement a redundant backup for controlling the disconnection or connection of the power supply line.

FIG. 3 shows a schematic block diagram of a leakage current detection module 210 in an electric leakage protection device 200 according to an example embodiment of the present invention. The leakage current detection module 210 comprises a current transducer 211, a sampling circuit 212, a first filter circuit 213, a bias circuit 214, an amplification processing circuit 215, and a second filter circuit 216.

The current transducer 211 senses leakage current in a ground wire L1 (see FIGs. 4-7) passing through the current transducer 211. When there is a leakage current in the ground wire L1, a current signal output end of the current transducer 211 generates a corresponding leakage current signal.

The sampling circuit 212 is coupled to the current signal output end of the current transducer 211 for converting the leakage current signal into a sampling voltage signal. As previously described, a weak leakage current (e.g., of the order of mA) in the ground wire may cause damage to the human body, and in order to accurately detect the weak current, the current signal may be converted into a voltage signal so as to capture the occurrence of electric leakage more accurately.

An input end of the first filter circuit 213 is coupled to the sampling circuit 212 for converting the sampling voltage signal into a processed voltage signal. The first filter circuit 213 may filter out interference in the voltage signal to capture the occurrence of electric leakage more accurately.

The bias circuit 214 outputs a direct-current bias voltage to provide a direct current bias for the amplification processing circuit 215, such that the amplification processing circuit 215 can amplify an alternating current signal without losing the negative half cycles.

The amplification processing circuit 215 is coupled to an output end of the first filter circuit 213 and an output end of the bias circuit 214 for amplifying the processed voltage signal to obtain an amplified voltage signal. In this way, the weak voltage signal may be further amplified and thus easily detected, so as to capture the occurrence of electric leakage more accurately.

An input end of the second filter circuit 216 is coupled to an output end of the amplification processing circuit 215 for converting the amplified voltage signal into an electric leakage detection signal Sout (see FIGs. 4-7). The second filter circuit 216 may filter out interference in the amplified voltage signal to provide a reliable electric leakage detection signal to the control circuit 220.

The circuits constituting the leakage current detection module 210 are illustrated below with reference to FIGs. 4-7.

FIG. 4 shows a first example circuit 300 of a leakage current detection module 210 according to an example embodiment of the present invention.

As shown in FIG. 4, the current transducer 211 senses leakage current I1 on a main ground wire L1 passing through the current transducer and outputs a corresponding leakage current signal I2 at a current signal output end of the current transducer. The sampling circuit 212 is composed of, for example, a resistor R3, coupled to the output end of the current transducer 211 for converting the leakage current signal into a sampling voltage signal. The first filter circuit 213 is composed of, for example, a capacitor C1, used to filter the sampling voltage signal to generate a processed voltage signal. The bias circuit 214 outputs a direct-current bias voltage by means of, for example, resistor division. As shown in FIG. 4, the bias circuit 214 is composed of resistors R5 and R6 connected in series between a voltage source Vcc and ground, and a capacitor C3 connected between the ground and the junction of the two resistors R5 and R6.

The amplification processing circuit 215 is used to amplify the processed voltage signal to obtain an amplified voltage signal. In the circuit 300 in FIG. 4, the amplification processing circuit 215 may comprise an amplification circuit 301, a third filter circuit 302, and a buffer circuit 303.

The amplification circuit 301 is coupled to the output end of the first filter circuit 213 and the output end of the bias circuit 214 for amplifying the processed voltage signal to obtain an amplified signal. As shown in FIG. 4, the amplification circuit 301 is composed of resistors R1 and R2 and an operational amplifier OP-A. The resistors R1 and R2 are connected in series between the output end of the first filter circuit 213 and an output end of the operational amplifier OP-A, a negative end of the operational amplifier OP-A is connected to the junction of the resistors R1 and R2, and a positive end of the operational amplifier OP-A is connected to the output end of the bias circuit 214.

An input end of the third filter circuit 302 is coupled to an output end of the amplification circuit 301 for converting the amplified signal into a processed amplified signal. The third filter circuit 302 may further eliminate interference during amplification of the voltage signal. As shown in FIG. 4, the third filter circuit 302 is composed of resistors R7 and R8 connected in series, and a capacitor C5 connected between the ground and the junction of the two resistors R7 and R8. The resistors R7 and R8 are connected in series between the output end of the amplification circuit 301 and the buffer circuit 303.

An input end of the buffer circuit 303 is coupled to an output end of the third filter circuit 302 for converting the processed amplified signal into the amplified voltage signal. As shown in FIG. 4, the buffer circuit 303 is composed of a voltage follower composed of an operational amplifier OP-B to achieve buffering and signal isolation.

As shown in FIG. 4, the second filter circuit 216 is composed of an RC filter circuit composed of the resistor R4 and a capacitor C4 to convert the amplified voltage signal from the output end of the buffer circuit 303, or, from the buffer circuit 303, into an electric leakage detection signal Sout and then supply same to the control circuit 220.

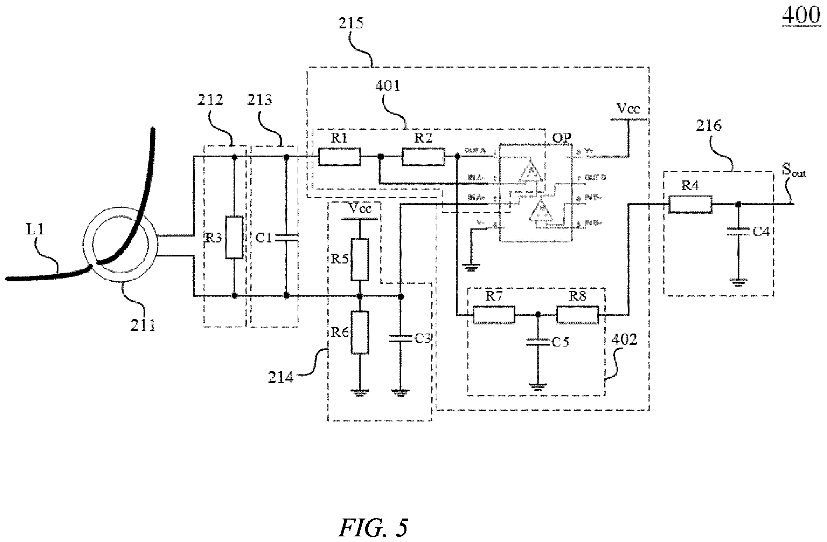

FIG. 5 shows a second example circuit 400 of a leakage current detection module 210 according to an example embodiment of the present invention. The circuit 400 has a structure similar to that of the circuit 300 in FIG. 4, and the difference lies in that the amplification processing circuit 215 in FIG. 5 comprises an amplification circuit 401 and a third filter circuit 402, but does not comprise a buffer circuit. The amplification circuit 401 has a circuit structure similar to that of the amplification circuit 301 in FIG. 4, and the third filter circuit 402 has a circuit structure similar to that of the amplification circuit 302 in FIG. 4. The amplification circuit 401 is coupled to the output end of the first filter circuit 213 and the output end of the bias circuit 214 for amplifying the processed voltage signal to obtain an amplified signal. An input end of the third filter circuit 402 is coupled to an output end of the amplification circuit 401 for converting the amplified signal into an amplified voltage signal, and an output end of the third filter circuit 402 is coupled to the second filter circuit 216 for providing the amplified voltage signal to the second filter circuit 216.

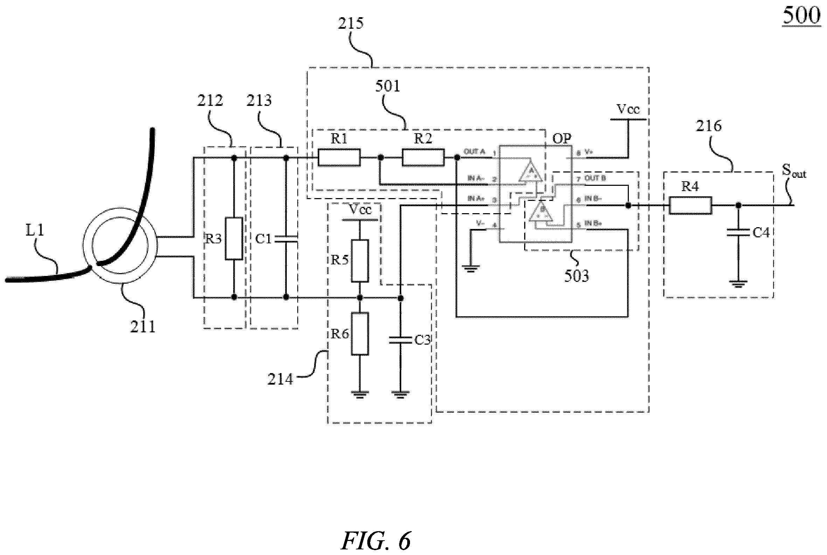

FIG. 6 shows a third example circuit 500 of a leakage current detection module 210 according to an example embodiment of the present invention. The circuit 500 has a structure similar to the circuit 300 in FIG. 4, and the difference lies in that the amplification processing circuit 215 in FIG. 6 comprises an amplification circuit 501 and a buffer circuit 503, but does not comprise a third filter circuit. The amplification circuit 501 has a circuit structure similar to that of the amplification circuit 301 in FIG. 4, and the buffer circuit 503 has a circuit structure similar to that of the buffer circuit 303 in FIG. 4. The amplification circuit 501 is coupled to the output end of the first filter circuit 213 and the output end of the bias circuit 214 for amplifying the processed voltage signal to obtain an amplified signal. An input end of the buffer circuit 503 is coupled to an output end of the amplification circuit 501 for converting the amplified signal into an amplified voltage signal, and an output end of the buffer circuit 503 is coupled to the second filter circuit 216 for providing the amplified voltage signal to the second filter circuit 216.

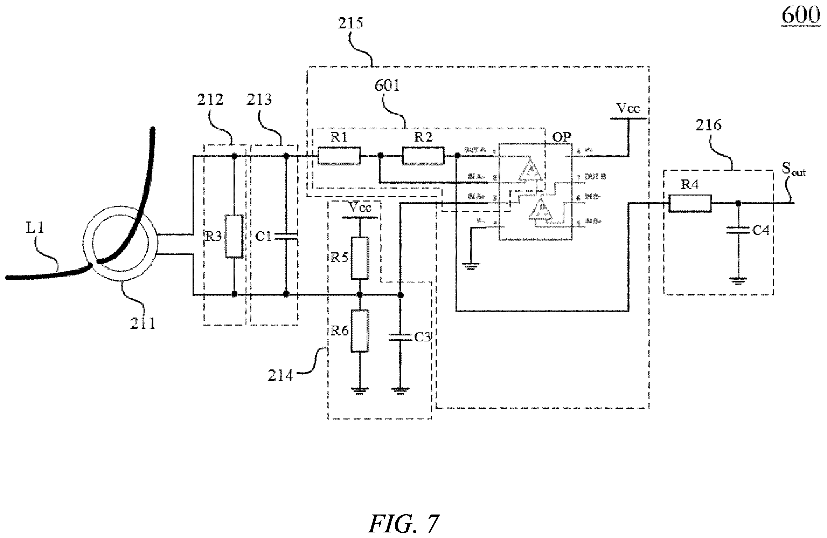

FIG. 7 shows a fourth example circuit 600 of a leakage current detection module 210 according to an example embodiment of the present invention. The circuit 600 has a structure similar to that of the circuit 300 in FIG. 4, and the difference lies in that the amplification processing circuit 215 in FIG. 7 comprises an amplification circuit 601, but does not comprise a third filter circuit and a buffer circuit. The amplification circuit 601 has a circuit structure similar to that of the amplification circuit 301 in FIG. 4. The amplification circuit 601 is coupled to the output end of the first filter circuit 213 and the output end of the bias circuit 214 for amplifying the processed voltage signal to obtain an amplified voltage signal, and an output end of the amplification circuit 601 is coupled to the second filter circuit 216 for providing the amplified voltage signal for the second filter circuit 216.

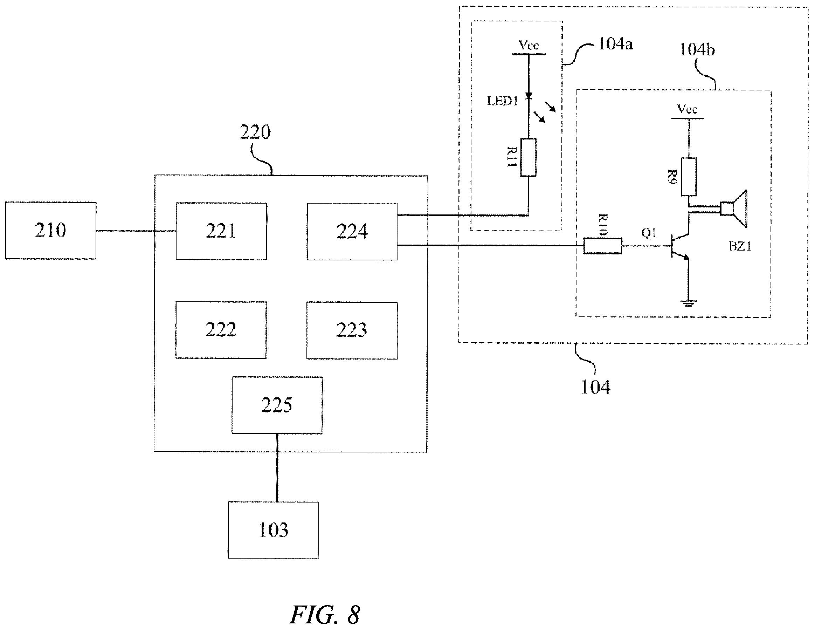

FIG. 8 shows an example logic circuit for achieving a control circuit 220, and connection thereof.

As shown in FIG. 8, the control circuit 220 comprises a first interface module 221 (e.g., an input interface) to receive the electric leakage detection signal Sout (with reference to FIGs. 4-7) from the leakage current detection module 210.

As shown in FIG. 8, the control circuit 220 further comprises a computation module 222 for computing the magnitude of the leakage current I1 in the main ground wire L1 according to the electric leakage detection signal Sout obtained from the first interface module 221. A computation process of the leakage current I1 is illustrated below with reference to FIG. 4.

When there is an alternating leakage current I1 in the main ground wire L1, a current signal output end of the current transducer 211 outputs a corresponding leakage current signal I2 = 11/a, where a is the ratio of turns on two sides of the current transducer 211.

After the leakage current signal I2 passes through the sampling circuit 212, an alternating sampling voltage signal V0 = I2 * R3 = I1 * R3/a is obtained.

The bias circuit 214 divides the voltage by means of the resistors R5 and R6 to obtain a direct-current bias voltage Vf = VCC * R6/(R5 + R6). The bias circuit 214 fixes a voltage of one end of the sampling circuit 212 (i.e., the resistor R3) at Vf, and a voltage of the other end is V1 = Vf - V0 = (VCC * R6/(R5 + R6)) - (I1 * R3/a). By means of selecting an appropriate turn ratio a, and parameter values of the resistors R3, R5 and R6, it is possible to make V1 greater than zero when the leakage current I1 is within a given range.

The voltage signal V1 is subjected to amplification processing by the amplification processing circuit 215 and filtering processing by the second filter circuit 216 and is then converted into an electric leakage detection signal Sout, and is provided to the control circuit 220, where Sout = Vf + (V0 * R2/R1) = (VCC * R6/(R5 + R6)) + (I1 * R3 * R2/(a * R1)).

Therefore, for a given parameter of each circuit of the leakage current detection module 210, the computation module 222 of the control circuit 220 may compute the leakage current I1 in the main ground wire L1 according to the electric leakage detection signal Sout, I1 = (Sout - (VCC * R6/(R5 + R6))) * a * R1/(R3 * R2). Since the parameters of the above circuits are given, the computation module 222 may be implemented by a preset computation circuit.

As shown in FIG. 8, the control circuit 220 further comprises a comparator 223 for comparing the computed leakage current I1 with a set threshold. As previously described, when the leakage current I1 exceeds a certain range, it may cause damage to the user.

As shown in FIG. 8, the control circuit 220 may further comprise a second interface module 224 (e.g., an output interface). The second interface module 224 is connected to the alarm module 104, and the control circuit 220 is used to control the alarm module 104 to give an alarm according to a comparison result of the comparator 223. For example, the control circuit 220 may transmit an alarm control signal to the alarm module 104 by means of the second interface module 224 in response to the leakage current I1 exceeding a set threshold, and the alarm module 104 gives the alarm in response to receiving the alarm control signal. For example, the alarm module 104 may comprise a display alarm circuit 104a and/or a sound alarm circuit 104b. As shown in FIG. 8, the display alarm circuit 104a is composed of, for example, a light indicator LED1, a resistor R11 and a power source Vcc. The second interface module 224 is connected to the resistor R11, and the control circuit 220 transmits the alarm control signal to the display alarm circuit 104a by means of the second interface module 224, such that the light indicator LED1 of the display alarm circuit 104a may give a light alarm according to the alarm control signal. As shown in FIG. 8, the sound alarm circuit 104b is composed of, for example, resistors R9 and R10, a switch Q1 (e.g., a triode, a MOS, various elements with a similar function, etc.), a sound indicator BZ1 (e.g., a buzzer, a horn, etc.) and a Vcc. The control circuit 220 transmits, by means of the second interface module 224, the alarm control signal to a control end of the switch Q1 (e.g., a base of a triode) of the sound alarm circuit 104b via the resistor R10 to control the on and off of the switch Q1, so as to control the sound indicator BZ1, connected to an output end of the switch Q1 (e.g., a collector of the triode), to gives the alarm.

As shown in FIG. 8, the control circuit 220 further comprises a third interface module 225 to be communicatively connected to the operation panel 103. For example, the third interface module 225 may be a serial communication interface.

Similarly, the control circuit 220 may further comprise other interface modules to be connected to the response device 105.

In the above example embodiments, the control circuit 220 may be implemented by any one of a microprogrammed control unit (MCU), a digital logic control circuit, or a pure hardware circuit implementing a similar function, as well known to those skilled in the art.

In the pool apparatus 100 and the electric leakage protection device 200 described according to FIGs. 1-8, the electric leakage protection device is internally disposed on the control board, which can enable real-time detection of the electric leakage of the ground wire without manual self-check by the user, can display the fault information in time after electric leakage occurs such that the user may know the system status and remove the fault, and may improve the system integration degree and is then convenient for the electric leakage protection device to communicate with other components of the pool apparatus by means of the control board.

The technical content and technical features of the present invention are disclosed above. However, it should be understood that, under the creative idea of the present invention, those skilled in the art would have made various changes and modifications to the concept disclosed above, which all fall within the scope of protection of the present invention.

The descriptions of the above example embodiments are illustrative but not restrictive, and the scope of protection of the present invention is defined by the claims.

It may be understood that the example embodiments described herein may be considered in a descriptive sense only and not for purposes of limitation. Descriptions of features or aspects within each example embodiment may be considered as available for other similar features or aspects in other example embodiments.

While example embodiments have been described with reference to the figures, it will be understood by those of ordinary skill in the art that various changes in form and details may be made therein without departing from the scope as defined by the following claims.

## Claims

1. An electric leakage protection device comprising:
a leakage current detection module (210) configured to detect whether there is a leakage current in a ground wire; and
a control circuit (220) operatively connected to the leakage current detection module (210),
wherein the leakage current detection module (210) transmits an electric leakage detection signal (Sout) to the control circuit (220) in response to detecting the leakage current.

2. The electric leakage protection device according to claim 1, wherein the leakage current detection module (210) comprises:
a current transducer (211) configured to sense the leakage current in the ground wire (L1) passing therethrough;
a sampling circuit (212) coupled to a current signal output end of the current transducer (211), and configured to obtain a sampling voltage signal;
a first filter circuit (213) comprising an input end coupled to the sampling circuit (212), and configured to convert the sampling voltage signal into a processed voltage signal;
a bias circuit (214) that outputs a direct-current bias voltage;
an amplification processing circuit (215) coupled to an output end of the first filter circuit (213) and to an output end of the bias circuit (214) and configured to amplify the processed voltage signal and thereby obtain an amplified voltage signal; and
a second filter circuit (216) comprising an input end coupled to an output end of the amplification processing circuit (215) and configured to convert the amplified voltage signal into the electric leakage detection signal.

3. The electric leakage protection device according to claim 2, wherein the amplification processing circuit (215) comprises:
an amplification circuit (301, 401) coupled to the output end of the first filter circuit (213) and to the output end of the bias circuit (214) and configured to amplify the processed voltage signal and thereby obtain an amplified signal; and
a third filter circuit (302, 402) comprising an input end coupled to an output end of the amplification circuit (301, 401) and configured to convert the amplified signal into the amplified voltage signal.

4. The electric leakage protection device according to claim 2, wherein the amplification processing circuit (215) comprises:
an amplification circuit (301, 501), coupled to the output end of the first filter circuit (213) and to the output end of the bias circuit (214) and configured to amplify the processed voltage signal to obtain an amplified signal; and
a buffer circuit (303, 503) comprising an input end coupled to an output end of the amplification circuit (301, 501) and configured to convert the amplified signal into the amplified voltage signal.

5. The electric leakage protection device according to claim 2, wherein the amplification processing circuit (215) comprises:
an amplification circuit (301) coupled to the output end of the first filter circuit (213) and to the output end of the bias circuit (214) and configured to amplify the processed voltage signal and thereby obtain an amplified signal; and
a third filter circuit (302) comprising an input end coupled to an output end of the amplification circuit (301) and configured to convert the amplified signal into a processed amplified signal; and
a buffer circuit (303) comprising an input end coupled to an output end of the third filter circuit and configured to convert the processed amplified signal into the amplified voltage signal.

6. The electric leakage protection device according to claim 2, wherein the amplification processing circuit (215) comprises: an amplification circuit (301, 401, 501, 601) coupled to the output end of the first filter circuit (213) and to the output end of the bias circuit (214) and configured to amplify the processed voltage signal and thereby obtain the amplified voltage signal.

7. The electric leakage protection device according to claim 1, further comprising an alarm module (104), wherein the control circuit (220) is further connected to the alarm module (104) and configured to control the alarm module (104) to output an alarm.

8. The electric leakage protection device according to claim 1, further comprising an operation panel (103) of a pool apparatus (100), wherein the control circuit (220) is operatively connected to the operation panel (103) and thereby receives a control command that is input by a user by means of the operation panel (103).

9. The electric leakage protection device according to claim 8, wherein the operation panel comprises a display screen.

10. The electric leakage protection device according to claim 9, wherein the control circuit (220) is communicatively connected to the display screen through serial communication.

11. The electric leakage protection device according to claim 9, wherein the control circuit (220) transmits fault information associated with the ground wire to the display screen, and thereby controls the display screen to display the fault information.

12. The electric leakage protection device according to claim 1, wherein the control circuit (220) is configured to connect to an external device (108) via a wireless network (107), and to thereby receive a control command that is input by a user from the external device (108) via the wireless network (107).

13. The electric leakage protection device according to claim 12, wherein the control circuit (220) transmits fault information associated with the ground wire to the external device (108) via the wireless network (107).

14. The electric leakage protection device according to claim 1, wherein the control circuit (220) is further connected to at least one response device (105) of the pool apparatus (100), and
the electric leakage protection device (200) further comprises a switch module (230), coupled between a power interface (106) and the at least one response device (105), and configured to control a power connection of a power supply line between the power interface (106) and the at least one response device (105),
wherein the control circuit (220) is further connected to the switch module (230) and configured to control the switch module (203) to establish or break the power connection.

15. A pool apparatus, comprising a pool body and a control box, wherein the control box comprises:
a control board; and
an electric leakage protection device (200), arranged on the control board, according to any one of claims 1-14.

16. The pool apparatus according to claim 15, wherein the pool apparatus (100) further comprises an operation panel (103), and the control circuit (220) is connected to the operation panel (103) of the pool apparatus (100) and is thereby configured to receive a control command that is input by a user by means of the operation panel (103).

17. The pool apparatus according to claim 16, wherein the pool apparatus further comprises at least one response device (105), and
the control circuit (220) is further connected to the at least one response device (105); and the electric leakage protection device (200) further comprises a switch module (230), coupled between a power interface (106) and the at least one response device (105), and is configured to control power connection of a power supply line between the power interface (106) and the at least one response device (105),
wherein the control circuit (220) transmits a switch control signal to the switch module (230) according to the electric leakage detection signal (Sout) and is thereby configured to control the switch module (230) to establish or break the power connection.
